# EUROPEAN PATENT SPECIFICATION

(11) **EP 0 395 412 B1**
(45) Date of publication and mention of the grant of the patent: **28.05.1997**
(21) Application number: 90304533.4
(22) Date of filing: 26.04.1990
(51) Int. Cl.: C08J 7/06

(54) **Transparent barrier film and method**
Transparente Sperrfolie und Verfahren
Pellicule de barrière transparente et procédé

(30) Priority: 26.04.1989 US 343900
(43) Date of publication of application: 31.10.1990
(73) Proprietor: FLEX PRODUCTS, INC., Santa Rosa, CA 95407-7370 (US)
(72) Inventor: Phillips, Roger W, Santa Rosa, California 95405 (US); Coombs, Paul G., Santa Rosa, California 95405 (US); Wendt, Lauren R., Santa Rosa, California 95403 (US)
(74) Representative: Bayliss, Geoffrey Cyril

(56) References cited:
- EP-A- 0 130 754
- WO-A-88/08043
- US-A- 4 756 964

## Description

This invention relates to a water vapour and oxygen barrier film and more particularly to acolourless flexible plastic film which is provided with a barrier coating formed of a graphite material that substantially reduces the Water Vapour Transmission Rate (WVTR) and Oxygen Transmission Rate (OTR).

Barrier films have heretofore been provided as in US-A-4702963 which have many desirable characteristics. However, the film in that specification has one inherent characteristic which is undesirable in certain applications because it has an amber colour. In certain situations it is desirable to ascertain when a product changes colour as, for example, turns yellow. This is difficult to ascertain in an amber-coloured film. In US-A-4557946, organosilicone are films disclosed with a protective film provided by utilising a plasma polymerised organosilicone material having an inorganic component. These plasma deposited films are deposited onto heated substrates (approximately 180°C) in order to achieve adequate adhesion and impermeability. In an article entitled "Variable Angle Spectroscopic Ellipsometry" by Alterovitz et al. published in Solid State Technology for March, 1988 there is a disclosure of ellipsometric experiments which were carried out which included the analysis of moisture penetration of dielectrics. One insulator studied was a plasma deposited semitransparent amorphous carbon film on a silicon substrate. The article pointed out that analysis showed that after immersion for several hours, hot water did not penetrate any carbon film 250 Angstroms or thicker. This article did not address gaseous water permeation, only aqueous water permeation.

US-A-4756964 discloses a barrier film which utilises an amorphous carbon coating which is produced by the use of a hydrocarbon gas in the presence of a plasma. There is no disclosure of such an amorphous carbon coating having moisture barrier properties.

WO-A-88/08043 discloses the use of magnetron sputtering to deposit carbon on polymers of low surface energy to provide a surface treatment to improve bondability and printability. There is no disclosure that such a coating would have barrier properties. Furthermore none of the published information discloses or suggests how the need for a substantially colourless transparent barrier film could be made. There is therefore a need for a new and improved and substantially colourless transparent barrier film.

In general, it is an object of the invention to provide a substantially colourless barrier film of good overall visual transmission.

This invention provides a substantially transparent barrier film comprising a flexible plastic substrate having first and second surfaces and a barrier coating on at least one of said surfaces formed to provide low oxygen permeability; wherein the substrate is transparent, the barrier coating is formed of amorphous carbon having a thickness ranging from 5 to 30 nanometers (50 to 300 Å), formed by electron beam evaporation of a graphite target, the barrier film has a neutral to light grey colour, and the barrier film has a reduced water transmission rate and a reduced oxygen transmission rate with respect to the uncoated substrate and a visible transparency of 30% or greater.

The following is a description of some specific embodiments of the invention reference being made to the accompanying drawings in which:-
Figure 1 is a cross-sectional view of a barrier film incorporating the present invention in which a barrier coating is utilised on only one side of the substrate;
Figure 2 is a cross-sectional view of a barrier film incorporating the present invention in which a barrier coating is provided on both sides of the substrate;
Figure 3 is a cross-sectional view similar to Figure 1, but showing the use of an organic overcoat on the barrier coating;
Figure 4 is a cross-sectional view of a barrier film of the type shown in Figure 2 with an organic overcoat provided on the barrier coatings on both sides of the substrate;
Figure 5 is a cross-sectionaol view of a barrier film of the type shown in Figure 1 in a laminated structure; and
Figure 6 is a cross-sectional view of a barrier film of the type shown in Figure 2 in a laminated structure.

In general, it is an object of the present invention to provide a barrier film which is comprised of a flexible substantially transparent substrate having first and second surfaces. A barrier coating is formed on at least one of the surfaces of the substrate and is formed of a graphite material having a thickness ranging from 50 to 300 Angstroms. In the method, the graphite material is deposited by use of an electron beam.

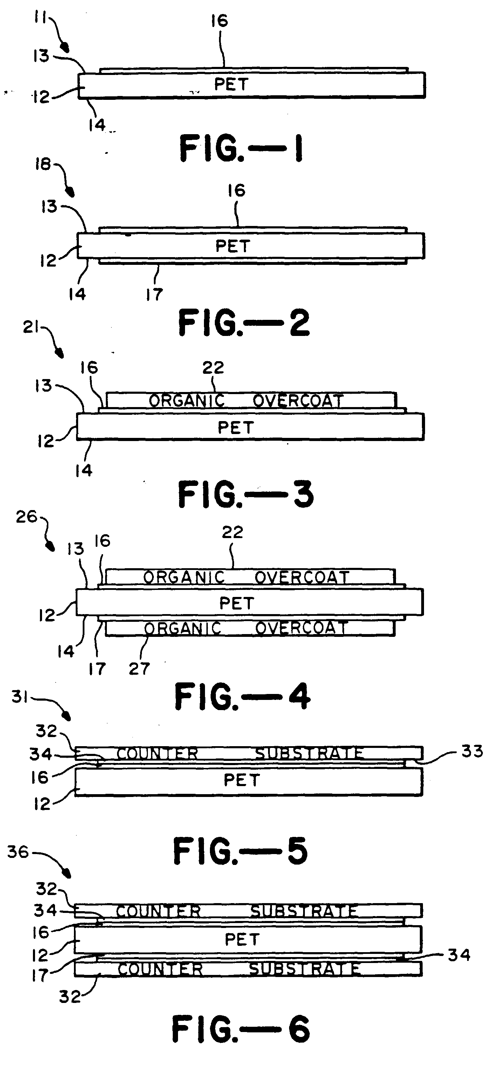

As shown in Figure 1 of the drawings, the barrier film 11 is comprised of a flexible substrate 12 formed of a suitable plastic such as a polymer. A polyester such as polyethylene terephthalate (PET) can be utilised having a thickness ranging from 0.00254 to 0.01778 centimetres (1 to 7 mils). The substrate is provided with first and second surfaces 13 and 14. The substrate in accordance with the present invention should be transparent or substantially transparent to visible light. A barrier coating 16 is formed on at least one surface, as for example, the surface 13 shown in Figure 1. The barrier coating 16 in accordance with the present invention is formed of an amorphous carbon-like material such as graphite deposited to a thickness ranging from 5 to 30 nanometers (50 to 30 Angstroms) depending upon the water vapour transmission rate (WVTR) and the oxygen transmission rate (OTR) requirements desired. Higher thicknesses can be used, but at thicknesses above 30 nanometers (300 Angstroms), the optical transmittance of the barrier film plus substrate is reduced to below 30% and is thus not considered as being substantially transparent to visible light. Thus the same materials may be used to produce an opaque barrier film where the thickness of the barrier coating less the substrate would range from 30 to 100 nanometers (300 to 1000 Angstroms).

The barrier coating of the graphite material is deposited utilising an electron gun to evaporate the graphite in a conventional vacuum chamber. The graphite barrier coating 16 can be deposited in a single pass or,if desired,in multiple passes so that the total thickness is the same as for the single pass. Even though the graphite material is generally a very opaque material, it has been found that at the thickness of 5 to 30 nanometers (50 to 300 Angstroms) it still can provide good transmission characteristics at the barrier levels desired. Although the graphite barrier coating has a colour, in the thickness utilised for the barrier coating, the colour is relatively neutral or a very light grey which becomes slightly darker at greater thicknesses of up to 30 nanometers (300 Angstroms).

It has been found that the graphite barrier coating has good adhesion. Utilising a conventional 3M tape adhesive pull-off test (see MIL-C-675A) the barrier coating will pass that test. The graphite barrier coating also passes the cheese cloth test by withstanding from 60 to 120 cheesecloth rubs before any scratches appear in the coating. The graphite barrier coating does not crack or flake off when the flexible plastic substrate 12 is creased or flexed.

The thin film shown in figure 1 has been tested for its permeability to oxygen and water. It readily passes medical specifications for oxygen and water permeability for packaging films. By way of example, it has been found that a substrate 12 formed of a 0.00508 cm (2 mil) PET provided a 55% overall visual transmission and a WVTR of 0.31 grams/m²/day at 30.8°C (.02 grams per 100 square inches per 24 hour period at 100°F) and at 90% relative humidity and an OTR of 0.62 cc/m²/day at 22.8°C (.04 cubic centimeters per 100 square inches per day at 74°F)at one atmosphere and a relative humidity of 0%.

When additional impermeability is required, an additional barrier coating 17 can be provided on the surface 14 on the other side of the substrate 12 as shown in Figure 2 which can be formed of the same material to the same thickness as the barrier coating 16. Thus there is provided in a barrier film 18 which has approximately twice the moisture and oxygen impermeable characteristics of the barrier film 11 shown in Figure 1 with only one barrier coating. The barrier film 18 because of the two barrier coatings 16 and 17 has a reduced optical transmission compared to the transmission of the barrier film 11 shown in Figure 1.

In order to achieve still further improved characteristics for the barrier film a barrier film 21 is shown in Figure 3 in which an organic overcoat 22 is deposited on the barrier film 21. The organic overcoat substantially increases the impermeability of the barrier coating 16 even though the organic overcoat in and of itself had very little, if any, effect on the vapour barrier characteristics of the plastic substrate 12. Various types of organic coatings can be provided. For example, Emerez™ 1533 polyamide manufactured by Emery Industries was mixed in a common solvent, tetrahydrofuran (THF) at a ratio of 25% to 75% by weight respectively. Another organic coating was formed by taking 25% of the Emerez 1533 solution and combining it with 1,6-diisocyanatohexane (HDI, a cross-linker) and a 1% polymethyl trifluoropropylsiloxane (Petrarch PS 181™) in THF solution at a ratio of 96.4%, 1.5%, 2.1%, respectively by weight. Another organic coating contained 95.6% of the 25% E1533, 1.9% toluene diisocyanate (TDI) and 2.4% of the 1% PS 181™. Optimum results were achieved using an organic overcoat in the form of a polyamide coating without the use of cross-linkers or special solvents because it was found that their additions did not significantly affect the characteristics of the organic overcoat.

These organic coatings were applied in a wet layer of 0.0127 cm (.005 inches) thick to provide a final coating of 0.00229 cm (0.0009 inches) to 0.00254 cm (0.0010 inches) thick after evaporation of the THF. The samples containing HDI and TDI were baked at 100°C for 30 minutes to activate the cross-linker.

The placement of the graphite barrier coating on the plastic film achieved a reduction in WVTR of more than 90%. The WVTR was further reduced by another 50 to 60% by the application of the organic overcoating hereinbefore described.

When still further improved capability is desired, a graphite barrier film 26 of the type shown in Figure 4 can be provided with an additional organic overcoat 27 provided on the second barrier coating 17 so that there is provided a graphite barrier coating on both surfaces of the flexible substrate as well as an organic overcoat on both graphite barrier coatings.

In Figure 5 there is shown another embodiment of the present invention in which the graphite barrier film is utilised in a laminated structure 31. The structure 31, as shown in Figure 5, is comprised of the substrate 12 and the graphite layer 16 hereinbefore described. A flexible plastic layer 32 is provided formed of a suitable laminating film, as for example, polypropylene, polyester or a heat sealable film. One surface 33 of the layer 32 is coated with a suitable laminate adhesive 34. The counter substrate 32 with the adhesives 34 can then be secured to the barrier film comprised of the substrate 12 and the graphite layer 16 to provide the composite structure 31 which has the excellent barrier characteristics hereinbefore described and which also can be heat sealed to itself. This makes it possible to utilise the layered or laminated structure 31 shown in Figure 5 for making self-contained bags which can be sealed on themselves by the use of heat. For example, polypropylene can be sealed on itself. Thus, a bag can be made with such a material which could be filled with a liquid. In such an orientation, the liquid would face the polyester, or alternatively, if desired the polypropylene or the polyethylene could face the liquid. The main criteria are that the graphite layer is covered and that the heat sealable material face inwardly so that the bag can be self-sealed by the application of heat.

Another embodiment of the invention is shown in Figure 6 in which another laminated structure 36 is shown utilising a graphite barrier film of the present invention in which an additional flexible plastic layer is laminated to both sides of the barrier film 18 shown in Figure 2. A laminating layer 32 of the type hereinbefore described is provided with a laminate adhesive 34 so that, for example, heat sealable plastic layers can be provided on both sides of the graphite barrier film 18 as shown in Figure 2. In this way, it is possible to provide a structure which permits heat sealing on either side so that bags can be formed by folding the laminated structure 36 so that either side can be folded inwardly onto itself or to the other surface and sealed.

From the foregoing it can be seen that there has been provided a flexible graphite barrier film which has excellent water vapour and oxygen impermeability characteristics and which has a neutral or light grey colour. The visual transmission preferably can vary from 30 to 70%. The graphite barrier film of the present invention has achieved adequate adhesion and low levels of impermeability where the barrier film has been deposited on substrates at room temperature. Calculations show that the graphite barrier coating described herein is inherently a better barrier against water vapour than the coating described in U.S. Patent No. 4557946. The permeability constant for the present film is calculated to be approximately 10⁻¹³ cc cm/cm² sec. cm Hg vs 10⁻⁹ cc cm/cm² sec. cm Hg for the coating disclosed in U.S. Patent No. 4557946. Thus, the graphite coating herein reported has four orders of magnitude lower permeability constant.

## Claims

1. A substantially transparent barrier film comprising a flexible plastic substrate having first and second surfaces and a barrier coating on at least one of said surfaces formed to provide low oxygen permeability; characterised in that the substrate is substantially transparent, in that the barrier coating is formed of amorphous carbon having a thickness ranging from 5 to 30 nanometers (50 to 300 Å) formed by electron beam evaporation of a graphite target, in that the barrier film has a neutral to light grey colour, and in that the barrier film has a reduced water transmission rate and a reduced oxygen transmission rate with respect to the uncoated substrate and a visible transparency of 30% or greater.

2. A barrier film as claimed in Claim 1
characterised in that an additional barrier coating identical to the first named barrier coating is formed on the other of said first and second surfaces.

3. A barrier film as claimed in Claim 1,
characterised in that an organic overcoat overlies the barrier coating.

4. A barrier film as claimed in Claim 2,
characterised in that an organic overcoat overlies each of said first named and additional barrier coatings.

5. A barrier film as claimed in Claim 3 or Claim 4
characterised in that the organic overcoat is a polyamide.

6. A barrier film as claimed in any of the preceding claims, characterised in that a layer of flexible plastic material is laminated to said barrier coating.

7. A barrier film as claimed in Claim 6,
characterised in that said plastic material is of a material that can be sealed onto itself.

8. A barrier film as claimed in Claim 7,
characterised in that said plastic material is of a type that can be sealed onto itself by the use of heat.

9. A barrier film as claimed in Claim 2,
characterised in that flexible layers of plastic material are laminated to each of said first and additional barrier coatings.

10. A barrier film as claimed in Claim 9,
characterised in that an adhesive is disposed between the layers of plastic material and the first and additional barrier coatings.

11. A barrier film as claimed in Claim 10,
characterised in that said plastic layers are formed of a plastic material which can be sealed onto itself.

12. A barrier film as claimed in any of the preceding claims, characterised in that the bare substrate is formed of polyester and has a thickness ranging from 0.00254 to 0.01778 cm (1-7 mils), a visual transmission range of 30-70% in combination with the substrate, the substrate/barrier combination having a reduced moisture vapour transmission rate reduced from that of the bare substrate down to a value of 0.319 gm/m²/day at 30.8°C (bare substrate to 0.2 grams per 100 square inches per 24-hour period at 100°F) at 90% relative humidity and a reduced oxygen transmission rate reduced from that of the bare substrate down to a value of 0.62 cm³/m²/day at 22.8°C (bare substrate to 0.04 cubic centimeters per 100 square inches per day at 74°F) at one atmosphere and a relative humidity of 0%.

## Patentansprüche

1. Im wesentlichen transparente Sperrschicht mit einem flexiblen Kunststoffsubstrat mit einer ersten und einer zweiten Oberfläche und einer Sperrbeschichtung auf mindestens einer der Oberflächen, die so beschaffen ist, daß sie für Sauerstoff eine niedrige Permeabilität aufweist, dadurch gekennzeichnet, daß das Substrat im wesentlichen transparent ist, daß die Sperrbeschichtung aus amorphem Kohlenstoff mit einer zwischen 5 und 30 nm (50 bis 300 Å) liegenden Dicke durch Elektronenstrahlverdampfung eines Graphittargets erzeugt wird, daß die Sperrschicht eine neutrale bis hellgraue Färbung aufweist und daß die Sperrschicht eine verringerte Wasserdurchlässigkeit und eine verringerte Sauerstoffdurchlässigkeit im Vergleich zum unbeschichteten Substrat und eine sichtbare Transparenz im sichtbaren Bereich von 30% oder mehr aufweist.

2. Sperrschicht nach Anspruch 1, dadurch gekennzeichnet, daß eine zusätzliche, mit der zuerst genannten Sperrschicht identische Sperrschicht auf der jeweils anderen der beiden Oberflächen (der ersten und der zweiten Oberfläche) erzeugt wird.

3. Sperrschicht nach Anspruch 1, dadurch gekennzeichnet, daß eine organische Überschicht die Sperrschicht überdeckt.

4. Sperrschicht nach Anspruch 2, dadurch gekennzeichnet, daß eine organische Überschicht den zuerst genannten und die zusätzliche Sperrschicht überdeckt.

5. Sperrschicht nach Anspruch 3 oder Anspruch 4, dadurch gekennzeichnet, daß die organische Überschicht ein Polyamid ist.

6. Sperrschicht nach einem der vorhergehenden Ansprüche, dadurch gekennzeichnet, daß eine Schicht flexiblen Kunststoffmaterials in einem Schichtverfahren auf die Sperrbeschichtung aufgebracht wird.

7. Sperrschicht nach Anspruch 6, dadurch gekennzeichnet, daß das Kunststoffmaterial aus einem Material ist, das mit sich selbst verschweißt werden kann.

8. Sperrschicht nach Anspruch 7, dadurch gekennzeichnet, daß das Kunststoffmaterial aus einem Material ist, das durch Wärmeeinwirkung mit sich selbst verschweißt werden kann.

9. Sperrschicht nach Anspruch 2, dadurch gekennzeichnet, daß flexible Schichten aus Kunststoffmaterial durch ein Schichtverfahren jeweils auf die erste und die zusätzliche Sperrbeschichtung aufgebracht werden.

10. Sperrschicht nach Anspruch 9, dadurch gekennzeichnet, daß ein Kleber zwischen den Kunststoffmaterialschichten und der ersten und der zweiten Sperrbeschichtung vorhanden ist.

11. Sperrschicht nach Anspruch 10, dadurch gekennzeichnet, daß die Kunststoffschichten aus einem Kunststoffmaterial sind, das mit sich selbst verschweißt werden kann.

12. Sperrschicht nach einem der vorhergehenden Ansprüche, dadurch gekennzeichnet, daß das bloße Substrat aus Polyester geformt ist und eine Dicke zwischen 0,00254 und 0,01778 cm (1-7 Mil) hat, in Kombination mit dem Substrat eine Transparenz im sichtbaren Bereich von 30-70% aufweist, die Substrat/Sperrschicht-Kombination eine verringerte Feuchtigkeitsdampfdurchlässigkeit, die bei einer relativen Luftfeuchtigkeit von 90% von derjenigen des bloßen Substrats bis zu einem Wert von 0,319 g/m²/Tag bei 30,8°C reicht (bloßes Substrat bis 0,2 g pro 100 Zoll² pro 24 h bei einer Temperatur von 100°F), und eine verringerte Sauerstoffdurchlässigkeit, die bei Atmosphärendruck und einer relativen Luftfeuchtigkeit von 0% von derjenigen des bloßen Substrats bis zu einem Wert von 0,62 cm³/m²/Tag bei 22,8°C reicht (bloßes Substrat bis 0,04 cm³ pro 100 Zoll² pro Tag bei 74°F), aufweist.

## Revendications

1. Film barrière pratiquement transparent comprenant un substrat de plastique souple ayant une première et une seconde surfaces et un revêtement barrière sur au moins l'une desdites surfaces formé pour leur conférer une faible perméabilité à l'oxygène ; caractérisé en ce que le substrat est pratiquement transparent, en ce que le revêtement barrière est constitué de carbone amorphe sous une épaisseur de 5 à 30 nanomètres (50 à 300 Å) formé par évaporation par faisceau électronique d'une cible de graphite, en ce que le film barrière a une couleur gris neutre à clair et en ce que le film barrière a un taux de transmission d'eau réduit et un taux de transmission d'oxygène réduit par rapport au substrat non revêtu et une transparence dans le visible de 30% ou davantage.

2. Film barrière selon la revendication 1, caractérisé en ce qu'un revêtement barrière supplémentaire identique au premier revêtement barrière nommé est formé sur l'autre desdites première et seconde surfaces.

3. Film barrière selon la revendication 1, caractérisé en ce qu'une couche de finition organique recouvre le revêtement barrière.

4. Film barrière selon la revendication 2, caractérisé en ce qu'une couche de finition organique recouvre chacun dudit premier revêtement barrière et dudit revêtement supplémentaire.

5. Film barrière selon la revendication 3 ou la revendication 4, caractérisé en ce que la couche de finition organique est un polyamide.

6. Film barrière selon l'une quelconque des revendications précédentes, caractérisé en ce qu'une couche de matière plastique souple est stratifiée sur ledit revêtement barrière.

7. Film barrière selon la revendication 6, caractérisé en ce que ladite matière plastique est constituée d'une matière qui peut être scellée sur elle-même.

8. Film barrière selon la revendication 7, caractérisé en ce que ladite matière plastique est d'un type qui peut être scellé sur lui-même par l'utilisation de chaleur.

9. Film barrière selon la revendication 2, caractérisé en ce que des couches souples de matière plastique sont stratifiées sur chacun dudit premier revêtement barrière et dudit revêtement supplémentaire.

10. Film barrière selon la revendication 9, caractérisé en ce qu'un adhésif est disposé entre les couches de matière plastique et le premier revêtement barrière et le revêtement barrière supplémentaire.

11. Film barrière selon la revendication 10, caractérisé en ce que lesdites couches plastiques sont formées d'une matière plastique qui peut être scellée sur elle-même.

12. Film barrière selon l'une quelconque des revendications précédentes, caractérisé en ce que le substrat nu est constitué de polyester et a une épaisseur allant de 0,00254 à 0,01778 cm (1-7 mils), un intervalle de transmission visuelle de 30 à 70% en combinaison avec le substrat, la combinaison substrat/barrière ayant un taux de transmission de la vapeur d'eau réduit, par rapport à celui du substrat nu, à une valeur de 0,319 g/cm²/jour à 30,8°C (pour le substrat nu, à 0,2 gramme pour 100 in² par période de 24 heures à 100°F) à 90% d'humidité relative et un taux de transmission de l'oxygène réduit par rapport à celui du substrat nu, à une valeur de 0,62 cm³/m²/jour à 22,8°C (substrat nu à 0,04 centimètre cube pour 100 in² par jour à 74°F) sous une atmosphère et à une humidité relative de 0%.
